# EUROPÄISCHE PATENTSCHRIFT

(11) **EP 0 334 110 B1**
(45) Veröffentlichungstag und Bekanntmachung des Hinweises auf die Patenterteilung: **15.09.1993**
(21) Anmeldenummer: 89104130.3
(22) Anmeldetag: 08.03.1989
(51) Int. Cl.: H01L 31/18, H01L 31/02

(54) **Verfahren zum Herstellen von polykristallinen Schichten mit grobkristallinem Aufbau für Dünnschichthalbleiterbauelemente wie Solarzellen**
Process for producing polycristalline layers with large crystals for thin film semiconductor devices, like solar cells
Procédé de fabrication de couches polycristallines à gros cristaux pour composants à semi-conducteurs en couches minces, en particulier des cellules solaires

(30) Priorität: 24.03.1988 DE 3810023
(43) Veröffentlichungstag der Anmeldung: 27.09.1989
(73) Patentinhaber: SIEMENS AKTIENGESELLSCHAFT, 80333 München (DE)
(72) Erfinder: Plättner, Rolf, Dr., D-8012 Riemerling (DE)

(56) Entgegenhaltungen:
- EP-A- 0 025 872
- EP-A- 0 179 719
- EP-A- 0 180 751
- EP-A- 0 221 767
- WO-A-82/03639
- DE-A- 3 049 226
- US-A- 3 953 876
- US-A- 4 706 376
- J. ELECTROCHEM. SOC.: SOLID-STATE SCIENCE AND TECHNOLOGY, Band 122, Nr. 12, Dezember 1975, Seiten 1681-1685; T.L. CHU et al.: "Polycrystalline silicon on coated steel substrates"
- PROCEEDINGS OF THE 7TH INTERNATIONAL CONFERENCE, ON PHOTOVOLTAIC SOLAR ENERGY, Sevilla, 27.-31. Oktober 1986, Seiten 860-864, D. Reibel Publishing Company; L. AMMOR et al.: "Improvement of polycrystalline silicon cells by adsorption of hydrogen"
- THE CONFERENCE RECORD OF THE 20TH IEEE PHOTOVOLTAIC SPECIALISTS CONFERENCE, Las Vegas, Nevada, 26.-30. September 1988, Band II, Seiten 1405-1408, IEEE, New York, US; I. REIS et al.: "Recrystallized silicon thin film structures for solar cells"

## Beschreibung

Die Erfindung betrifft ein Verfahren zum Herstellen von polykristallinen Schichten mit grobkristallinem Aufbau wie sie für Dünnschichthalbleiterbauelemente, insbesondere für Silizium-Solarzellen verwendet werden, durch Abscheidung der polykristallinen Schicht aus der Gas- oder Dampfphase auf isolierende oder elektrisch-leitende oder mit einem Überzug aus elektrisch leitendem Material versehene Substrate und anschließender Wärmebehandlung zur Rekristallisation.

Die Notwendigkeit zur Kostenreduzierung von Solarzellen erfordert neue kostengünstige Verfahren zur Herstellung dünner Halbleiterschichten. Bisherige Verfahren, wie zum Beispiel die epitaktischen Aufwachsverfahren zur Erzeugung einkristalliner Schichten auf geeigneten Substraten sind für diese Anwendungen zu aufwendig und werden deshalb nicht benutzt, obwohl sie zu höchster Qualität der dünnen Halbleiterschichten führen.

Verschiedenartige Verfahren zur Herstellung von Solarzellen sind zum Beispiel aus der Zeitschrift VDI-Z-121 (1979), Nr. 8 - April auf den Seiten 389 bis 393 zu entnehmen.

Aus DE-A-3049226 ist ein Verfahren zur Erzeugung einer polykristallinen Siliziumschicht mittels CVD und anschließender Rekristallisierung durch Wärmebehandlung bekannt, wobei eine Zwischenschicht aus Siliziumdioxid den Einfluß des Metallsubstrates auf die Rekristallisierung verhindert.

Aus EP-A-0180751 ist ein Verfahren zur Herstellung einer polykristallinen Galliumarsenidschicht auf billigem Substrat bekannt, wobei direkt über dem Substrat eine Zwischenschicht aus amorphem Germanium erzeugt wird, in der Zwischenschicht an vorbeschriebenen Punkten Gebiete mit definierter Kristallorientierung durch Bestrahlung erzeugt werden und die Galliumarsenidschicht schließlich durch Gasphasenepitaxie darüber abgeschieden wird. Die Zonen vorgegebener Kristallorientierung müssen durch hochenergetische Strahlung erzeugt werden und für die Erzeugung der Galliumarsenidschicht sind Epitaxieverfahren erforderlich. Die polykristalline Schicht besitzt eine Grenzfläche zwischen zwei unterschiedlichen Halbleitermaterialien.

Aus Chn et al., J. Electrochem. Soc. 122(12), Seiten 1681-1685 (1975) ist es bekannt, vor der Abscheidung von polykristallinem Silizium durch CVD auf einem Stahlsubstrat eine Barriereschicht aus Wolfram oder Borsilikatglas zu erzeugen.

Bei dem aus EP-A-0221767 bekannten Verfahren wird eine Halbleiterschicht über einer Isolationsschicht erzeugt, in der elektrisch leitende Partikel enthalten sind, die als Kristallisationszentren für die Halbleiterschicht dienen. Die Isolationsschicht wird dabei zusammen mit den darin enthaltenen elektrisch leitfähigen Partikel erzeugt, beispielsweise durch Dispersion von Silizium in einer Aluminiumschmelze (siehe Spalte 8, Zeilen 37 bis 49).

Aus EP-A-0025872 ist eine Solarzelle bekannt, bei der eine polykristalline Siliziumschicht über einer amorphen Siliziumschicht aus optischen Gründen angeordnet ist. Zum Herstellverfahren ist angegeben, daß eine Aluminiumschicht die Kristallisation der polykristallinen Siliziumschicht begünstigt.

Für Anwendungen, bei denen Defekte in der kristallinen aktiven Halbleiterschicht in bezug auf den Wirkungsgrad der Zelle toleriert werden können, wie zum Beispiel bei den Solarzellen, sind kostengünstige Substrate als Träger für darauf hergestellte dünne Schichten wünschenswert. So werden zum Beispiel Metallbleche dafür benutzt. Die Schichten können darauf aus der Gasphase abgeschieden werden. Vorzugsweise kommen dabei Verfahren in Betracht, die mit niedrigeren Temperaturen arbeiten. Dies kommt einerseits der Materialauswahl für die Substrate, aber auch der Erniedrigung der Energiekosten des Verfahrens entgegen.

Die entstehenden Schichten haben aber zunächst weitgehend den Nachteil, daß sie eine zu große Zahl von Korngrenzen enthalten; die Korndurchmesser liegen typisch bei Werten kleiner 1 µm. Zur Verbesserung dieser Qualität ist es möglich, diese Schichten zu rekristallisieren. Dazu werden zum Beispiel geheizte Graphitstäbe in geringem Abstand zur Schichtoberfläche über die Schicht geführt oder, es wird mit einer geeigneten Lampe und Optik die Schicht oberflächlich rekristallisiert. Hohe Flächengeschwindigkeiten können erreicht werden. Problematisch ist dabei aber der Einfluß eines kristallinen Substrates, da dessen Kristallstruktur den Vorgang der Rekristallisation ungünstig beeinflussen kann, oder es wird die Rekristallisation sogar verhindert, weil Mikrokristallite des Substrates stets auf die darauf befindlichen dünnen Schichten einwirken.

Die Erfindung dient der Lösung der Aufgabe, bei der nach der Abscheidung einer polykristallinen Schicht auf einem Substrat erfolgenden Rekristallisation den Einfluß des Kristallaufbaus des Substrates auszuschalten.

Dies wird bei einem Verfahren der eingangs genannten Art erfindungsgemäß dadurch erreicht, daß vor dem Aufbringen der polykristallinen Si-Schicht eine amorphe Si-Zwischenschicht, die wesentlich dünner als die polykristalline Schicht ist, niedergeschlagen wird und mit der polykristallinen Schicht rekristallisiert wird. Dabei ist vorgesehen, die amorphe Zwischenschicht mit einem Raster von Kristallisationszentren auf elektrischen Wege zu versehen. Die eingeprägten Kristallisationspunkte verursachen bei einem anschließenden Rekristallisationsprozeß, daß nur wenige Keime in der entstehenden Schicht wachsen und somit ein grobkristalliner Schichtaufbau entsteht. Kristallitflächen von 1 bis 100 mm² können erreicht werden.

Weitere Ausgestaltungen der Erfindung ergeben sich aus den Unteransprüchen.

Es zeigen
- die Figur 1: eine Schichten folge zur Herstellung grobkristalliner Schichten und
- die Figuren 2 bis 4: verschiedene Möglichkeiten zur Einprägung eines Rasters von Kristallisationspunkten in die amorphe Zwischenschicht.

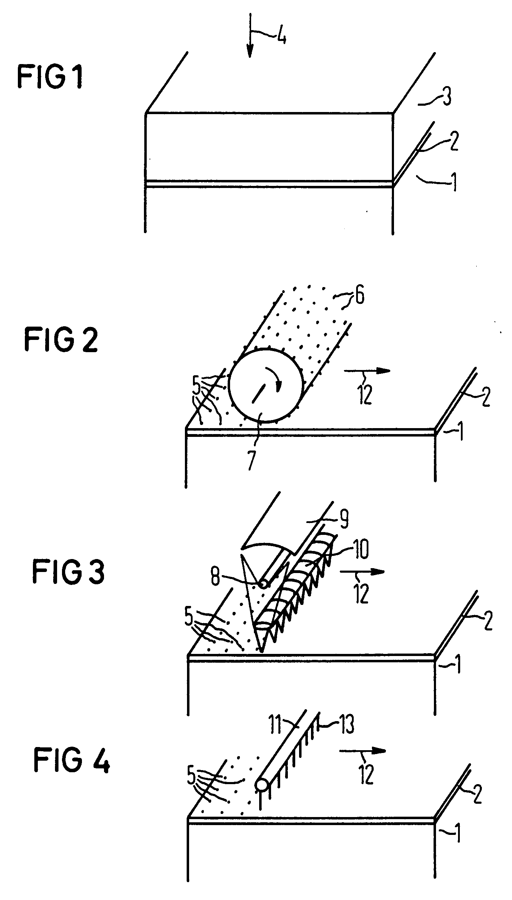

In Figur 1 wird von einem Substrat mit feinkristalliner Struktur, beispielsweise einem dünnen Edelstahlband 1 ausgegangen, auf dem eine ca. 1 bis 5 nm dicke amorphe Siliziumdioxidschicht 2 durch Abscheidung aus Silan (SiH₄) in Sauerstoffatmosphäre im Glimmentladungsplasma aufgebracht wird. Ein Verfahren zum Herstellen amorpher Siliziumschichten mittels des Glimmentladungsplasmas ist beispielsweise aus der DE-OS 27 43 141 bekannt. Auf die amorphe Zwischenschicht 2 wird eine polykristalline Siliziumschicht 3 in einer Schichtdicke von zum Beispiel 20 µm durch Abscheidung aus der Gasphase nach thermischer Zersetzung von Silan aufgebracht. Durch Zufuhr von Rekristallisationsenergie zum Beispiel von oben (siehe Pfeil 4), beispielsweise mittels geheizter Graphitstäbe, wird die polykristalline Siliziumschicht 3 ohne Beeinflussung des feinkristallinen Aufbaus des Substrates 1 in den grobkristallinen Zustand übergeführt.

Dieses Verfahren ist insbesondere anwendbar zur Herstellung grobkristalliner Siliziumschichten für Solarzellen. Die Zwischenschicht 2 wird hier zum Beispiel aus amorphem Silizium oder bei Metallsubstraten (1) zu deren elektrischen Isolation aus amorphem Siliziumdioxid (2) hergestellt. Restliche Korngrenzen können nach der Rekristallisation (4) dieser Schicht (3) noch durch Wasserstoffpassivierung verringert werden.

In Form von Dickschicht-Solarzellen werden die Vorteile der Dünnfilm-Technologie durch das Verfahren gemäß der Erfindung für polykristallines Silizium nutzbar. Zum Beispiel können die Schichten durch Strukturierung als streifenförmige Zellen ausgebildet und in bekannter Weise in Serie verschaltet werden.

Das Verfahren eignet sich jedoch außer für Solarzellen auch für andere Anwendungen, bei denen Materialschichten mit großen grobkristallinen Kristallitflächen von Vorteil sind.

Figur 2: Es ist möglich, der amorphen Zwischenschicht 2 äußerlich ein Raster von Kristallisationspunkten 5 aufzuprägen, wobei der bevorzugte Rasterabstand im Bereich von 5 mm liegen sollte. In Figur 2 erfolgt dies auf mechanischem Wege durch Überrollen einer, mit in entsprechenden Abständen angeordneten Nadeln 6 bestückten Walze 7 über die Oberfläche der auf dem Substrat 1 befindlichen amorphen Schicht 2.

Figur 3 zeigt die Erzeugung des Rasters 5 auf optischem Wege. Dabei wird ein lichtoptisches streifenförmiges System, bestehend aus stabförmiger Lichtquelle 8, Reflektor 9 und einem Linsensystem 10 in Pfeilrichtung 12 über die Oberfläche (1, 2) bewegt.

In Figur 4 ist die Erzeugung des Rasters 5 mit elektrischen Mitteln dargestellt. Dabei wird eine Elektrode 11 mit Spitzen 13 in Pfeilrichtung 12 über die Oberfläche (1, 2) geführt.

Es ist aber auch möglich, das Raster (5) durch Ätzen eines Lochmusters in die amorphe Zwischenschicht (2) zu erzeugen.

## Patentansprüche

1. Verfahren zur Herstellung einer polykristallinen Siliziumschicht auf einem Substrat (1) mit einer zumindest an der Oberfläche kristallinen Struktur, bei dem
- aus der Gas- oder Dampfphase eine Zwischenschicht (2) aus amorphem Silizium auf dem Substrat (1) abgeschieden wird, die wesentlich dünner ist, als die zu erzeugene polykristalline Schicht,
- in der Zwischenschicht (2) ein Raster von Kristallisationszentren (5) auf elektrischem Weg erzeugt wird,
- über der Zwischenschicht (2) mit dem Raster (5) eine polykristalline Schicht (3) aus der Dampf- oder Gasphase abgeschieden wird, und abschließend
- die polykristalline Schicht (3) unabhängig vom Substrat (1) rekristallisiert wird.

2. Verfahren nach Anspruch 1,
bei dem das Raster (5) durch punktförmige Funkenentladung erzeugt wird.

3. Verfahren nach Anspruch 1,
bei dem das Raster (5) durch punktförmiges Aufheizen mittels einer Widerstandsdrahtheizung (11, 3) erzeugt wird.

4. Verfahren nach Anspruch 3,
bei dem die Widerstandsdrahtheizung (13) in einer Leiste (11) integriert ist, die über die Oberfläche der Zwischenschicht (2) bewegt wird.

5. Verfahren nach einem der Ansprüche 1 bis 4,
bei dem Zwischenschicht (2) in einem Glimmentladungsplasma abgeschieden wird.

6. Verfahren nach einem der Ansprüche 1 bis 5,
bei dem ein geheizter Graphitstab über die Oberfläche der polykristallinen Schicht (3) geführt wird, um diese zu rekristallisieren.

7. Verfahren nach einem der Ansprüche 1 bis 6,
bei dem im Anschluß an den Rekristallisationsprozeß ein Temperprozeß in einer Wasserstoffatmosphäre durchgeführt wird.

## Claims

1. Process for producing a polycrystalline silicon layer on a substrate (1) having a structure which is crystalline at least at the surface, in which process
- an interlayer (2) which is composed of amorphous silicon and which is substantially thinner than the polycrystalline layer to be produced is deposited on the substrate (1) from the gas or vapour phase,
- a grid of crystallisation centres (5) is produced electrically in the interlayer (2),
- a polycrystalline layer (3) is deposited from the vapour or gas phase over the interlayer (2) containing the grid (5), and finally
- the polycrystalline layer (3) is recrystallised independently of the substrate (1).

2. Process according to Claim 1, in which the grid (5) is produced by punctiform spark discharge.

3. Process according to Claim 1, in which the grid (5) is produced by punctiform heating by means of a resistance wire heater (11, 3).

4. Process according to Claim 3, in which the resistance wire heater (13) is integrated in a strip (11) which is moved across the surface of the interlayer (2).

5. Process according to one of Claims 1 to 4, in which interlayer (2) is deposited in a glow discharge plasma.

6. Process according to one of Claims 1 to 5, in which a heated graphite rod is passed over the surface of the polycrystalline layer (3) in order to recrystallise the latter.

7. Process according to one of Claims 1 to 6, in which, following the recrystallisation process, a heat-treatment process is carried out in a hydrogen atmosphere.

## Revendications

1. Procédé de préparation d'une couche de silicium polycristalline sur un substrat (1) ayant une structure cristalline au moins à la surface, qui consiste
- à déposer en phase gazeuse ou en phase vapeur, sur le substrat (1), une couche (2) intermédiaire en silicium amorphe sensiblement plus mince que la couche polycristalline à produire,
- à produire par voie électrique, dans la couche (2) intermédiaire, un réseau de centres de cristallisation (5),
- à déposer en phase vapeur ou en phase gazeuse, sur la couche (2) intermédiaire ayant le réseau (5), une couche (3) polycristalline, et enfin
- à recristalliser la couche (3) polycristalline indépendamment du substrat (1).

2. Procédé suivant la revendication 1,
qui consiste à produire le réseau (5) par décharge d'étincelle ponctuelle.

3. Procédé suivant la revendication 1,
qui consiste à produire le réseau (5) par chauffage ponctuel au moyen d'un chauffage (11, 3) à fil résistant.

4. Procédé suivant la revendication 3,
qui consiste à intégrer le chauffage (13) à fil résistant dans une baguette (11), qui est déplacée au-dessus de la surface de la couche (2) intermédiaire.

5. Procédé suivant l'une des revendications 1 à 4,
qui consiste à déposer la couche intermédiaire dans un plasma de décharge luminescente.

6. Procédé suivant l'une des revendication 1 à 5,
qui consiste à faire passer un crayon de graphite chauffé au-dessus de la surface de la couche (3) polycristalline pour la recristalliser.

7. Procédé suivant l'une des revendication 1 à 6,
qui consiste à effectuer, à la suite du processus de recristallisation, un processus de recuit dans une atmosphère d'hydrogène.
